# EUROPÄISCHE PATENTSCHRIFT

(11) **EP 2 120 143 B1**
(45) Veröffentlichungstag und Bekanntmachung des Hinweises auf die Patenterteilung: **31.08.2011**
(21) Anmeldenummer: 08008827.1
(22) Anmeldetag: 13.05.2008
(51) Int. Cl.: G06F 9/48, G06F 17/50

(54) **Verfahren zur Ausführung von Tasks zur Berechnung eines zu simulierenden Signals in Echtzeit**
Method to perform tasks for calculating a signal to be simulated in real time
Procédé d'exécution de tâches destinée au calcul d'un signal devant être simulé en temps réel

(43) Veröffentlichungstag der Anmeldung: 18.11.2009
(60) Teilanmeldung: 10015461.6
(73) Patentinhaber: dspace digital signal processing and control engineering GmbH, 33102 Paderborn (DE)
(72) Erfinder: Müller Björn, 59557 Lippstadt (DE); Dr. Krügel Karsten, 33098 Paderborn (DE); Klahold Jürgen, 33034 Brakel (DE)
(74) Vertreter: COHAUSZ DAWIDOWICZ HANNIG & SOZIEN

(56) Entgegenhaltungen:
- ING-RAY CHEN: "ON APPLYING IMPRECISE COMPUTATION TO REAL-TIME AI SYSTEMS" COMPUTER JOURNAL, OXFORD UNIVERSITY PRESS, SURREY, GB, Bd. 38, Nr. 6, 1. Januar 1995 (1995-01-01), Seiten 434-442, XP000580407 ISSN: 0010-4620
- LUI SHA: "Dependable system upgrade" REAL-TIME SYSTEMS SYMPOSIUM, 1998. PROCEEDINGS. THE 19TH IEEE MADRID, SPAIN 2-4 DEC. 1998, LOS ALAMITOS, CA, USA,IEEE COMPUT. SOC, US, 2. Dezember 1998 (1998-12-02), Seiten 440-448, XP010318773 ISBN: 978-0-8186-9212-3
- BUTTAZZO ET AL: "Hard Real-Time Computing Systems: Predictable Scheduling Algorithms and Applications (Second Edition), Handling overload conditions" REAL-TIME SYSTEMS SERIES, SPRINGER, Bd. 23, 1. Oktober 2004 (2004-10-01), Seiten 233-279, XP002475695 ISBN: 978-0-387-23137-2

## Beschreibung

Die Erfindung betrifft ein Verfahren zur Ausführung wenigstens eines Task zur Berechnung wenigstens eines zu simulierenden Signals in Echtzeit mittels eines auf einer Datenverarbeitungsanlage mit einem Echtzeitbetriebssytem in Software implementierten Taskmanagers, der periodisch jeweils nach einer vorgegebenen vorgebbaren Periodendauer einen Task startet, welcher aus wenigstens einem vorgegebenen Eingangssignal wenigstens ein davon abhängiges Ausgangssignal berechnet, und auf der Datenverarbeitungsanlage eine Menge von wenigstens zwei verschiedenen Tasks mit unterschiedlichen Berechnungszeiten zur Berechnung desselben wenigstens einen zu simulierenden Signals ausführbar gespeichert sind und wenigstens ein Minimaltask eine Berechnungszeit kürzer als die Periodendauer aufweist, wobei der Taskmanager wenigstens einen der Tasks aus der Menge nach einer gespeicherten Strategie startet, mit welcher unter Einhaltung der Echtzeit innerhalb der gegebenen Periodendauer ein Berechnungsergebnis wenigstens eines der Tasks aus der Menge erhalten wird.

Ein solches Verfahren ist aus dem Dokument "On Applying Imprecise Computation to Real-Time AI Systems" von Ing-Ray Chen, veröffentlicht in Computer Journal, Oxford University Press, Surrey, GB, Bd. 38, Nr. 6, 1. Januar 1995, Seiten 434-442, XP000580407 ISSN:0010-4620, bekannt.

Im Stand der Technik ist es bekannt, Sachverhalte der realen Welt technisch mittels Datenverarbeitungsanlagen zu simulieren. Dabei wird insbesondere zum Test von technischen Komponenten, wie beispielsweise Steuergeräten, insbesondere Kraftfahrzeugsteuergeräten, bevorzugt, eine Echtzeitsimulation durchzuführen, d.h. eine Simulation, bei der ein außen stehender Betrachter die durch die Simulation erzeugten Ereignisse so wahrnimmt, als würden sie tatsächlich in realer Zeit geschehen.

Bei der Echtzeitsimulation kann es durch zu komplexe Modelle zu Problemen bezüglich der Berechnungszeit bzw. der Güte der durchgeführten Berechnungen kommen. Dementsprechend kann es vorkommen, dass beim Einsatz zu komplexer Modelle Probleme auftreten, beispielsweise also, dass die Einhaltung der Echtzeit während einer Simulation nicht gewährleistet werden kann unter gleichzeitiger Erzielung korrekter Berechnungsergebnisse.

Beispielsweise können solche Probleme entstehen durch die Verwendung von anderen Modellen als den bekannten Mittelwertmodellen in der Motorsimulation. In der Regel wird heutzutage zur Simulation im automotiven Umfeld das Euler-Verfahren mit einer festen Schrittweite zur numerischen Approximation von physikalischen Systemen benutzt. Dabei stellt es sich für einen Ingenieur als schwierig dar, eine Schrittweite aufzufinden, die zum einen die numerische Stabilität des Gesamtsystems gewährleistet und zum anderen die Echtzeitfähigkeit des Systems zu keiner Zeit gefährdet. So kann es demnach vorkommen, dass zu komplexe Modelle programmiert werden, die eine zu große Berechnungszeit benötigen und somit das Simulationsergebnis nicht in Echtzeit liefern können. Hierbei wird bei der hier beschriebenen Erfindung unter dem Begriff der Komplexität von durchzuführenden Berechnungstasks verstanden, dass mit steigender Komplexität die Berechnungszeit eines Tasks steigt. Ein Task ist dabei eine Berechnungsvorschrift, um aus Eingangssignalen davon abhängige Ausgangssignale zu berechnen. Insgesamt kann somit der Wunsch nach einer höheren Komplexität oder aber die Notwendigkeit nach einer höheren Komplexität die Echtzeitfähigkeit der dafür vorzunehmenden Berechnungen gefährden.

Im Stand der Technik ist es somit bekannt, wie eingangs genannt, einen Task zur Berechnung eines zu simulierenden Signals durchzuführen, wobei es bekanntermaßen vorgesehen sein kann, einen in Software implementierten Taskmanager zu verwenden, der periodisch jeweils nach einer vorgegebenen / vorgebbaren Periodendauer einen solchen Task startet.

Dabei sind bisherige Programmierungen derart vorgenommen worden, dass ein zu startender Task garantiert innerhalb der vorgegebenen Periodendauer seine Berechnung abschließt, um die Echtzeitfähigkeit nicht zu gefährden. Hier kann es in Einzelfällen vorkommen, dass der Abschluss der Berechnung die zur Verfügung stehende Rechenzeit innerhalb einer vorgegebenen Periodendauer nicht ausschöpft, beispielsweise da der ausgeführte Task zu bestimmten Zeitpunkten oder bei bestimmten gegebenen Umständen schneller als erwartet gerechnet werden konnte. Es zeigt sich somit, dass in einer solchen Situation ein genauerer Task hätte berechnet werden können, als es tatsächlich durchgeführt wurde. Die Rechenkapazitäten der simulierenden Datenverarbeitungsanlage werden demnach ersichtlich nicht ausgeschöpft, um immer auf der sicheren Seite der Echtzeitfähigkeit zu bleiben.

Im Stand der Technik ist es dabei weiterhin bekannt, zur Erzielung einer möglichst hohen Genauigkeit unter gleichzeitiger Beibehaltung der Echtzeitfähigkeit, vor der Durchführung einer Simulation zu entscheiden, ob ein gewünschter Sachverhalt mit einem einfach modulierten Modell, also beispielsweise einem Task mit geringer Rechenzeit oder mit einem komplex formulierten Modell, somit also einem Task mit höherer Berechnungszeit, berechnet wird.

Ein Nachteil dieser Lösung liegt darin, dass immer vor der Simulation bereits festgelegt werden muss, mit welcher Komplexität eine Rechnung durchgeführt werden soll. Die Entscheidung, einen komplexen Task mit höherer Rechenzeit auszuwählen, ist dabei jedoch problembehaftet, da nicht immer im Vorfeld, d.h. vor der tatsächlichen Durchführung der Simulation, einwandfrei entschieden werden kann, ob die Möglichkeit besteht, den komplexformulierten Task tatsächlich unter Einhaltung der Echtzeit bei der konkret gegebenen Bedingung zu berechnen.

Im Stand der Technik ist ein Programm mit der Bezeichnung Mosilab des Fraunhofer-Institutes bekannt, welches ebenfalls versucht, diese Problematik zu lösen, wobei vor jeder Berechnung einer Task entschieden wird, ob ein Sachverhalt mit einem komplexen oder einfachen Task gerechnet werden soll. So ist es in Verbindung mit der Mosilab-Software bekannt, zwischen interessanten Zuständen eines Systems, z.B. die sich durch die Berechung vorangegangener Tasks oder Entscheidungen vor der Simulation ergeben und weniger interessanten Zuständen eines Systems zu unterscheiden und hiervon abhängig die Berechnung von einfachen oder komplexen Tasks vor der Simulation auszuwählen. Beispielsweise bei der Simulation der Arbeitsweise einer Solaranlage kann vor der Simulation von deren Verhalten bei Nacht entschieden werden, Rechenaufwand einzusparen. Weiterhin kann zwar vor einer Task entschieden werden, ob eine einfache oder komplexe Task berechnet werden soll, jedoch kann nicht immer vorher abgeschätzt werden, ob eine komplexe Task in Echtzeit berechnet werden kann. Somit ist auch die Mosilab-Software nicht geeignet, während der Durchführung einer Echtzeitsimulation Einfluss zu nehmen auf die zu berechnenden Tasks und deren Komplexität bzw. die damit einhergehende Rechenzeit.

Aufgabe der Erfindung ist es, ein Verfahren der eingangs genannten Art bereitzustellen, welches die Möglichkeit schafft, während der Laufzeit einer Simulation die Einhaltung der Echtzeit zu garantieren und dabei gleichzeitig alle Möglichkeiten ausschöpft, um möglichst genaue Simulationsergebnisse bei der Berechnung zu erzielen. Dabei kann die Ausführung der eingangs genannten Tasks sowohl für vollständige Modelle eines zu simulierenden Signals oder aber auch eines Teilmodells zur Simulation eines Signals vorgesehen sein. Die Nachteile des Standes der Technik, nach dem immer nur ein Task berechnet wird, der garantiert innerhalb der vorgegebenen Periodendauer zum Abschluss der Berechnung führt, sollen behoben werden. Außerdem soll flexibel und ohne Aufwand seitens des Nutzers auf technische Rahmenbedingungen reagiert werden. So soll z.B. berücksichtigt werden, dass auf einem schnellen Prozessor ggf. komplexere Task in Echtzeit berechnet werden können, als auf einem langsameren Prozessor.

Die Aufgabe wird erfindungsgemäß dadurch gelöst, dass bei einem gattungsgemäß benannten Verfahren in der Datenverarbeitungsanlage eine Information über die voraussichtlich zu erwartende Berechnungszeit der einzelnen Task gespeichert ist und gemäß der gespeicherten Strategie ein Task aus der Menge mit einer Berechnungszeit größer als die des Minimaltask gestartet wird und mit dem Starten dieses Task ein Timer gestartet wird, wobei der Taskmanager in Abhängigkeit der Differenz von Periodendauer und Zeitwert des Timers den gestarteten Task abbricht und den Minimaltask startet, wobei das Abbrechen erfolgt bei einem Zeitwert des Timers, wenn die Differenz aus Periodendauer und Zeitwert um eine Sicherheitszeit größer ist als die Berechnungsdauer des Minimaltask und wobei es sich bei dem gestarteten Task aus der Menge um einen der Tasks handelt, dessen erwartete Berechnungszeit geringer ist als die Timerzeit beim Abbruch des Task in einer vorherigen Berechnungsperiode.

Die Erwähnung, dass der Taskmanager periodisch einen Task startet schließ dabei nicht aus, insbesondere sogar erfindungsgemäß ein, dass gemäß den nachfolgend beschriebenen Strategien Tasks durch den Taskmanager auch aperiodisch gestartet werden können.

Unter einem zu simulierenden Signal wird dabei jede mögliche physikalische Größe verstanden, die durch ein Berechnungsergebnis eines Task repräsentiert werden kann, wie z.B. elektrische, optische oder akustische Signale, bei elektrischen Signalen insbesondere analoge oder digitale Signale, wie z.B. Spannungen oder Strömt. Solche Signale können z.B. durch Zahlenwerte repräsentiert werden, die aus den Berechnungen eines genannten Task resultieren. Es kann dabei insbesondere auch vorgesehen sein, dass aus den Berechnungsergebnissen der Simulation tatsächliche physikalische Signale gebildet werden, z.B. durch Digital-Analog-Wandlung, Ansteuerung von Stellantrieben etc.

Es ist somit der wesentliche Kerngedanke der Erfindung, ein zu simulierendes Signal nicht nur mit einer einzigen Komplexität und damit verbundener Berechnungszeit in einem Task zu modellieren, sondern dieses Signal in verschiedenen Modellen unterschiedlicher Komplexität und damit einhergehender unterschiedlicher Rechenzeit. Es besteht demnach erfindungsgemäß die Möglichkeit, anhand der gespeicherten Strategie aus den in der Menge unterschiedlicher Komplexität bzw. Berechnungszeit vorliegenden Tasks einen oder mehrere zur Berechnung auszuwählen und so immer innerhalb der vorgegebenen Periodendauer ein Berechnungsergebnis von wenigstens einem der Tasks zu erhalten. Um dabei die Simulation in Echtzeit in jedem Fall garantieren zu können, ist es erfindungsgemäß vorgesehen, dass einer der Tasks derart geringe Komplexität bzw. Rechenzeit aufweist, dass dieser Task garantiert immer innerhalb der vorgegebenen Periodendauer ausgeführt werden kann. Dieser Task, der ein Task aus der Menge der insgesamt zur Verfügung stehenden Tasks auf der Datenverarbeitungsanlage ist, wird nachfolgend weiterhin als Minimaltask bezeichnet, um ihn von den übrigen möglichen Tasks unterscheiden zu können.

Die auf der Datenverarbeitungsanlage, insbesondere in dem zur Verfügung gestellten in Software implementierten Taskmanager gespeicherte Strategie kann ebenso in der Software implementiert sein und bestimmt, wie der eingesetzte Taskmanager periodisch jeweils nach Ablaufen der genannten, damit verbundenen Periodendauer einen oder auch mehrere Tasks aus der zur Verfügung stehenden Menge startet. Hierbei ist die Strategie erfindungsgemäß so gewählt und in Software auf der genannten Datenverarbeitungsanlage implementiert, dass wie eingangs genannt, immer ein Berechnungsergebnis in Echtzeit innerhalb der zur Verfügung stehenden Periodendauer erhalten werden kann.

Erfindungsgemäß ist es vorgesehen, dass gemäß der gespeicherten Strategie ein Task aus der Menge mit einer Berechnungszeit größer als die des Minimaltasks gestartet wird und mit dem Starten dieses Tasks ein Timer gestartet wird, wobei der Taskmanager in Abhängigkeit der Differenz von Periodendauer und Zeitwert des Timers den gestarteten Task abbricht und den Minimaltask startet.

So wird gemäß dieser Strategie versucht, ein Berechnungsergebnis zu erhalten, welches genauer ist als ein Berechnungsergebnis, welches der Minimaltask mit der geringsten Berechnungszeit zur Verfügung stellen würde. Demnach wird ein Task gestartet, dessen Berechnungszeit von der des Minimaltasks abweicht, wofür die Berechnungszeit des Minimaltasks bevorzugterweise bekannt und gespeichert ist. Auch die Berechnungszeiten der übrigen Tasks, zumindest erwartete Berechnungszeiten der übrigen Tasks, können bekannt und gespeichert sein, so dass auch diese erwarteten Berechnungszeiten für eine Auswahl im Rahmen der Strategie zur Verfügung stehen können. Dabei müssen die erwarteten Berechnungszeiten nicht tatsächlich als Zeit bekannt sein, sondern es ist auch ausreichend, wenn die einzelnen, in der Menge gegebenen Tasks, lediglich hinsichtlich ihrer Berechnungszeit eine Abfolge aufweisen, die beispielsweise einer Priorität gleichkommen kann.

Mit dem gleichzeitigen Starten eines Timers wird dabei sicher gestellt, dass zu jeder Zeit während der Laufzeit des Tasks eine Information über die bereits verstrichene Zeit der Berechnung zur Verfügung steht. Aufgrund der bekannten Berechnungszeit des Minimaltasks kann demnach dafür Sorge getragen werden, dass ein gestarteter Task rechtzeitig abgebrochen werden kann, um nach dem Abbruch diesen Tasks innerhalb der verbleibenden Zeit bis zum Ende der Periodendauer immer noch garantiert den Minimaltask bis zum Abschluss der Berechnung durchführen zu können. So wird gemäß dieser Strategie versucht, ein genaueres Berechnungsergebnis zu erhalten, es wird jedoch in jedem Fall rechtzeitig die Ausführung des Minimaltasks gestartet, um das Berechnungsergebnis dieses Minimaltasks zu erhalten, wenn die Berechnung des zuvor gestarteten Tasks nicht rechtzeitig beendet werden kann.

Dabei ist es hier vorgesehen, dass das Abbrechen bei einem Zeitwert des Timers erfolgt, wenn die Differenz aus der Periodendauer, die insgesamt für die Berechnung zur Verfügung steht und dem Zeitwert des Timers um eine Sicherheitszeit größer ist als die Berechnungsdauer des Minimaltasks. Hier kann insbesondere der durch die Sicherheitszeit bereitgestellte Zeitpuffer vorgesehen sein, um Abweichungen in der Berechnungsdauer des Minimaltasks von der gespeicherten theoretischen Berechnungszeit für diesen Task zu kompensieren.

Um technisch das Abbrechen des laufenden Tasks und/oder das Starten des Minimaltasks zu realisieren, kann es vorgesehen sein, einen Interrupt zu verwenden. Interrupts sind in Datenverarbeitungsanlagen bekannt und können beispielsweise derart funktionieren, dass eine Interrupt-Signalleitung auf einem bestimmten, für den Interrupt vorgesehenen Signalpegel gezogen wird, um den Interrupt auszulösen.

Erhält eine Datenverarbeitungsanlage ein derartiges Interrupt-Signal, so kann eine Verzweigung zu einer Adresse im Speicher der Datenverarbeitungsanlage verfolgen, ab der ein dort gespeichertes Programm ausgeführt wird. So kann hier die Möglichkeit bestehen, in Abhängigkeit des Zeitwertes des Timers, also insbesondere dann, wenn die Differenz aus Periodendauer und Zeitwert um eine Sicherheitszeit größer ist als die Berechnungsdauer des Minimaltasks ein solcher Interrupt ausgelöst wird, beispielsweise dadurch, dass durch einen Timerbaustein, in welchem die Zeit hochgezählt wird, ein entsprechendes Interrupt-Signal erzeugt wird, beispielsweise dadurch, dass eine entsprechende Interrupt-Leitung auf den eingangs genannten, hierfür benötigten Signalpegel gelegt wird, insbesondere einen Groundpegel.

Es kann sodann mit einer durch den Interrupt gestarten Prozedur, bei welcher es sich um eine Prozedur des Taskmanagers handeln kann, überprüft werden, ob der ursprünglich begonnene Task bereits beendet ist. Ist dies nicht der Fall, so wird dieser Task abgebrochen und der Minimaltask gestartet. Ist jedoch der Task bereits beendet, so kann es beispielsweise vorgesehen sein, dass der Taskmanager bis zum Ablauf der Periodendauer abwartet, also keine weiteren Tasks startet. Alternativ kann es ebenso vorgesehen sein, dass bei einer Beendigung des Tasks vor dem Interrupt der Taskmanager aus der Menge der Tasks einen weiteren Task startet mit einer erwarteten Berechnungszeit, die größer ist als die des beendeten Tasks. So kann hier die Möglichkeit gegeben sein, bei einer noch zur Verfügung stehenden Berechnungszeit bis zum Ende der Periodendauer ein noch genaueres Ergebnis zu erzielen.

Gemäß einer möglichen Ausführung der Erfindung kann es hier vorgesehen sein, dass bei dieser Art der sequentiellen Abarbeitung derjenige Task aus der Menge gestartet werden kann, der die größte erwartete Berechnungsdauer aufweist bzw. als Task mit der höchsten Berechnungsgenauigkeit dem System bekannt ist. So kann das System immer erst versuchen, das genauestmögliche Berechnungsergebnis zu erzielen, jedoch die Berechnung abbrechen und den Minimaltask starten, wenn diese Berechnung nicht rechtzeitig in einer Zeit durchgeführt werden konnte, die genügend Restzeit zur alternativen Ausführung des Minimaltasks bereitstellt.

Insbesondere bei der periodischen Abfolge des Verfahrens kann es vorgesehen sein, dass aus der Menge ein Task gestartet wird, dessen erwartete Berechnungszeit geringer ist als die Timerzeit beim Abbruch des Tasks in einer vorherigen Berechnungsperiode. So besteht hier die Möglichkeit, aus Erfahrungswerten der Vergangenheit eine Art Lernen des Taskmanagers zu implementieren. Hat sich beispielsweise gezeigt bei einer vorherigen Bearbeitungsperiode, dass der ausgewählte Task nicht rechtzeitig beendet wurde, also sicherheitshalber der Minimaltask gestartet wurde, so kann es bei einer darauf folgenden Periode vorgesehen sein, einen Task mit einer geringeren Komplexität bzw. Berechnungszeit auszuwählen. Da bei der vorherigen Periode eine Timerzeit ermittelt wurde, nach der der zuvor gestartete Task abgebrochen wurde, kann nunmehr ein Task ausgewählt werden, dessen voraussichtlich zu erwartende Berechnungszeit geringer ist als diese Timerzeit, um mit einer Wahrscheinlichkeit zu erzielen, dass dieser Task vor einem Interrupt bis zum Ende ausgeführt werden kann. So kann der Taskmanager aus den vorherigen Ergebnissen lernen und versuchen, die Auswahl der in der Menge zur Verfügung stehenden Tasks zu optimieren, wobei es bei dieser Ausführung demnach vorgesehen sein kann, eine möglichst konkrete Information über die voraussichtlich zu erwartende Berechnungszeit der einzelnen Tasks in der Datenverarbeitungsanlage zusätzlich gespeichert zu haben.

Wie eingangs erwähnt, wird hier für eine Datenverarbeitungsanlage eine Menge von mehreren Tasks bereit gestellt, die alle für dasselbe zu simulierende Signal ein Simulationsergebnis berechnen können, hierfür jedoch unterschiedliche Rechenzeiten benötigen, wobei zumindest einer der Tasks als Minimaltask ausgeführt ist, der eine garantierte Berechnungszeit aufweist, die geringer ist als die zur Verfügung stehende Periodendauer. Unterschiede bei der Berechnungszeit der einzelnen Tasks können sich z.B. dadurch ergeben, dass die Schrittweite, mit welcher die Tasks Berechnungen durchführen, verschieden gewählt ist. Demnach kann ein Task mit einer höheren Berechnungsdauer eine geringere Schrittweite haben als ein Task mit einer geringeren Berechnungsdauer. Berechnungsdauern können sich ebenso unterscheiden durch die Solver, mit der die Tasks berechnet werden. So hat ein komplexer Task, also einer mit einer höheren Berechnungsdauer, einen ebenso komplexeren Solver als ein Task mit einer geringeren Komplexität.

Weitere Unterschiede in der Berechnungsdauer können sich auch dadurch ergeben, dass die Gleichungen, die innerhalb eines Tasks berechnet werden, verschiedene Genauigkeiten aufweisen, bevorzugt jedoch immer mit der gleichen Anzahl von Zuständen, insbesondere also Eingangsparametern für die Gleichungen. So können für Tasks mit höheren Rechenzeiten demnach genauere Gleichungen verwendet werden.

Weitere Unterschiede in der Berechnungszeit können sich auch dadurch ergeben, dass die Anzahl der zu berechnenden Funktionen oder die Anzahl der für die Berechnung verwendeten Parameter unterschiedlich sind. Ist es in einem hier nicht beschränkend zu verstehenden Beispiel vorgesehen, die Funktion eines Bremsen-Antiblockiersystems zu simulieren, so kann beispielsweise in einem Task mit geringerer Berechnungsdauer lediglich ABS-Funktionen, wie beispielsweise der Bremsdruck und die Raddrehung erfasst werden. In einem Task mit höherer Berechnungsdauer können demgegenüber zusätzliche Funktionen bzw. Parameter zu den vorgenannten, wie beispielsweise Bremsassistentfunktionen mitberücksichtigt werden, wie die die Geschwindigkeit, mit der auf das Bremspedal getreten wird und/oder die Geschwindigkeit, mit der das Gaspedal gelöst wird.

In einer mit allen möglichen Ausführungen kombinierbaren Weiterbildung kann es auch vorgesehen sein, die Periodendauer, nach der Task gestartet werden, zu ändern. Eine Umprogrammierung der Periodendauer kann z.B. während der Laufzeit der aktuellen Periodendauer erfolgen, so dass nach deren Ablauf sich folgende geänderte Periodendauern anschließen.

Allgemein kann es auch vorgesehen sein, dass das genannte erfindungsgemäße Verfahren nicht nur für ein einziges zu simulierendes Signal eingesetzt wird, sondern für viele verschiedene Signale, die ggfs. auch parallel berechnet werden.

Das hier vorgestellte erfindungsgemäße Verfahren kann technisch beispielsweise auf verschiedene Arten realisiert sein. Beispielsweise kann es vorgesehen sein, dass das Verfahren auf einer Datenverarbeitungsanlage abläuft, mittels der für ein reales elektronisches Steuergerät, beispielsweise ein Kraftfahrzeugsteuergerät, eine Testumgebung simuliert wird und wobei dem realen Steuergerät Signale und/oder Daten aus der simulierten Steuergeräteumgebung von der Datenverarbeitungsanlage zugeführt werden und das Steuergerät reale Signale und/oder berechnete Daten an die Datenverarbeitungsanlage sendet. So findet hier demnach ein Datenaustausch von realen und simulierten Signalen bzw. Daten zwischen einer Datenverarbeitungsanlage, auf der das erfindungsgemäße Verfahren läuft und einem tatsächlichen realen elektronischen Steuergerät statt. Diese Kommunikation der Signale oder Daten kann dabei beispielsweise leitungsgebunden über elektrische oder optische Signalleitungen oder auch funkgebunden stattfinden. Die entsprechenden Signale können hierbei an den dafür vorgesehenen Ports der jeweiligen Datenverarbeitungsanlage bzw. des elektronischen Steuergerätes zum Versenden zur Verfügung gestellt bzw. empfangen werden.

In einer anderen Alternative kann es auch vorgesehen sein, dass das Verfahren auf einem realen elektronischen Steuergerät, wie beispielsweise einem Kraftfahrzeugsteuergerät, ausgeführt wird, um dessen Steuerverhalten zu simulieren, wobei dem Steuergerät Signale und/oder Daten aus der realen Steuergeräteumgebung zugeführt werden, beispielsweise von Sensoren und Messwertaufnehmern und wobei das Steuergerät simulierte Signale und/oder simuliert berechnete Daten an die Steuergeräteumgebung abgibt, beispielsweise an Aktoren. Auch hier findet demnach eine entsprechende Kommunikation statt, die auf die gleiche Art und Weise vorgenommen werden kann, wie es zu der vorherigen Ausführung genannt ist.

In einer wiederum weiteren Möglichkeit kann es auch vorgesehen sein, dass das Verfahren auf einer Datenverarbeitungsanlage abläuft, mittels der das Steuerverhalten eines Steuergerätes, insbesondere eines Kraftfahrzeugsteuergerätes, simuliert wird, wobei der Datenverarbeitungsanlage Signale und/oder Daten aus der realen Steuergeräteumgebung, insbesondere von Sensoren und Messwertaufnehmern zugeführt werden oder aber auch hier eine Simulation vorgesehen ist, also beispielsweise von einer Datenverarbeitungsanlage zur Simulation einer Steuergeräteumgebung zugeführt werden und von der das Steuerverhalten simulierenden Datenverarbeitungsanlage simulierte Signale und/oder Daten an die reale oder simulierte Steuergeräteumgebung zugeführt werden. Es findet demnach auch hier wieder eine Kommunikation von Signalen und Daten in beiden Richtungen statt, wobei die an dieser Kommunikation teilhabenden Geräte entweder real sein können oder ihrerseits simuliert sind.

Es besteht so zusammengefasst die Möglichkeit, mit dem erfindungsgemäßen Verfahren in verschiedenen technischen Anwendungen die Echtzeitfähigkeit von Simulationen unter Erzielung möglichst genauer Berechnungsergebnisse bereit zu stellen.

Ausführungsbeispiele der Erfindung sind in den nachfolgenden Figuren dargestellt. Es zeigen:
- Figur 1: eine Variante, bei der ein Simulationsrechner die Umgebung für ein konkretes Steuergerät simuliert
- Figur 2: eine Variante, bei der im Steuergerät selbst die Simulation von dessen Steuerverhalten stattfindet
- Figur 3: das serielle Starten von Tasks, beginnend mit einem Task einer größeren Berechnungszeit im Vergleich zum Minimaltask

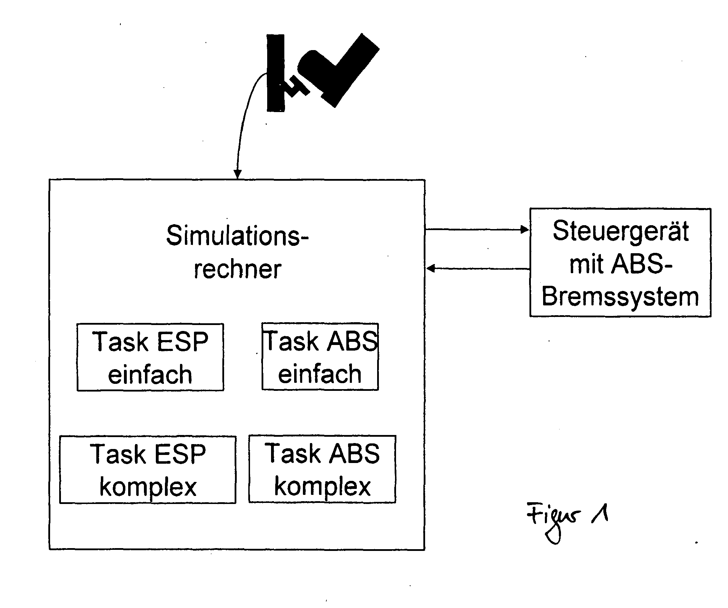

Die Figur 1 zeigt hier exemplarisch eine der möglichen, zuvor genannten Anwendungsmöglichkeiten, bei denen es vorgesehen ist, dass eine Datenverarbeitungsanlage als Simulationsrechner arbeitet und das eingangs beschriebene erfindungsgemäße Verfahren durchführt. Hier ist es vorgesehen, dass der Simulationsrechner eine Umgebung für ein konkretes reales Kraftfahrzeugsteuergerät simuliert. Zwischen dem simulierenden Rechner und dem konkreten Steuergerät findet ein Daten- bzw. Signalaustausch statt, beispielsweise bezüglich Signalen und Daten betreffend Informationen über die Straße, Geschwindigkeit, Radstellung etc. Es kann hier in diesem Beispiel das Verhalten des Steuergerätes hinsichtlich seines Steuerverhaltens in Verbindung mit einem Antiblockierbremssystem getestet werden. Die auf dem Simulationsrechner zur Durchführung des erfindungsgemäßen Verfahrens ablaufende Software und der darin implementierte Taskmanager startet gemäß einer vorgegebenen Strategie die dargestellten Tasks, wobei hier jeweils ein einfacher bzw. ein komplexer Task, d.h. ein solcher mit einer geringen bzw. einer höheren Berechnungszeit, jeweils für das Antiblockiersystem bzw. ein ESP-System zur Kontrolle des Schlupfes beim Anfahren oder Kurvenfahrten vorgesehen ist. Gemäß der gespeicherten Strategie werden die hier in der Menge der Tasks vorgesehenen Tasks seriell oder parallel berechnet und das Ergebnis der Berechnung an das Steuergerät bereitgestellt, um eine Umgebung, also z.B. das Fahren eines Autos auf einer Straße, dem Steuergerät zu simulieren und dessen Reaktionen auf die simulierte Umgebung in einer Kommunikation zurück zum Simulationsrechner zu erhalten.

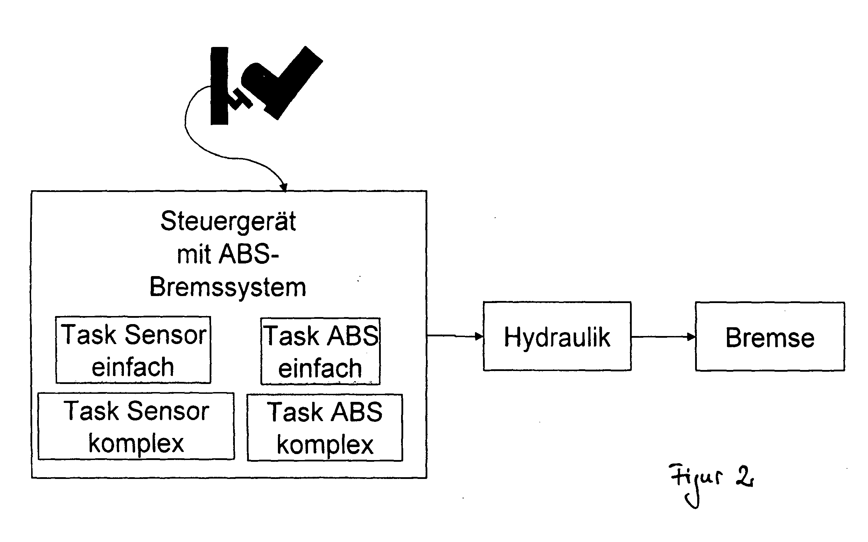

Die Figur 2 zeigt eine alternative Möglichkeit der Anwendung, bei der das Steuergerät selbst das erfindungsgemäße Verfahren durchführt, das Steuergerät also noch nicht hinsichtlich seiner elektronischen Ausgestaltung konkretisiert ist, sondern dessen Steuerverhalten softwareseitig simuliert wird. Auch hier kommt das erfindungsgemäße Verfahren zum Einsatz, wobei hier entsprechende Tasks von geringerer oder höherer Berechnungszeit, gekennzeichnet als "einfach" bzw. "komplex" vorgesehen sind. Nicht dargestellt ist es hier, dass dem Steuergerät zur Simulation seines Steuerverhaltens von außen Signale oder Daten zugeführt werden können, die beispielsweise von einer realen Umgebung stammen, beispielsweise aus einer Kraftfahrzeugumgebung, wobei anhand der so erhaltenen Daten oder Signale das Steuergerät durch Abarbeitung der Task gemäß den erfindungsgemäß möglichen Strategien Ausgangsgrößen zur Verfügung stellt, die unmittelbar die Hydraulik bzw. die Bremse des konkreten Kraftfahrzeugs beeinflussen können. Es ist darauf hinzuweisen, dass die hier dargestellten Anwendungen der Figuren 1 und 2 lediglich exemplarisch zu verstehend sind und keine Beschränkung des Verfahrens auf die hier genannten Anwendungen gegeben sind.

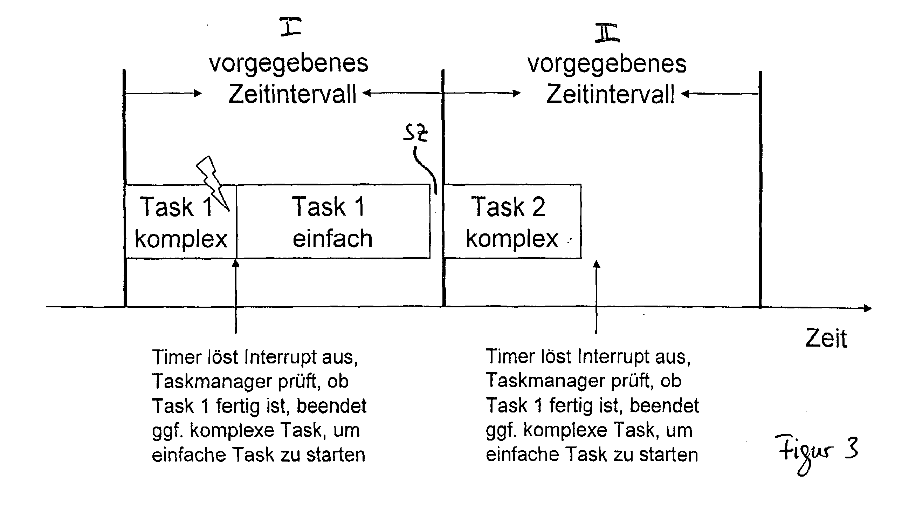

Die Figur 3 zeigt eine Ausfertigung der seriellen Abarbeitungsstrategie, gemäß der mit einem Task einer höheren Berechnungszeit im Vergleich zum Minimaltask, der hier als einfach gekennzeichnet ist, gestartet wird. Gleichzeitig mit dem Start des Tasks wird auch ein Timer gestartet, der nach einer vorgegebenen Zeit einen Interrupt auslöst. Diese Auslösung kann erfolgen, wie es im allgemeinen Teil dargestellt ist, um sicher zu stellen, dass in der verbleibenden Restzeit nach dem Auslösen des Interrupts und dem Ende der Periodendauer noch genügend Zeit zur Verfügung ist, um den Minimaltask zu starten. So zeigt es hier in der Periode 1 die Darstellung, gemäß der zum Interrupt der komplexe Task mit der höheren Berechnungszeit abgebrochen wird, um zu ermöglichen, dass in der verbleibenden Zeit bis zum Ende der Periodendauer noch der Minimaltask vollständig ausgeführt wird. Erkennbar ist hier, dass der Interrupt auslöst, wenn die Differenz aus der maximal zur Verfügung stehenden Periodendauer und dem Zeitwert des Timers größer ist als die Berechnungszeit, die der Minimaltask benötigt, hier größer ist um eine gewisse Sicherheitszeit SZ, die sich hier darin widerspiegelt, dass nach der Abarbeitung des Minimaltasks bis zum Ende der Periodendauer diese gewählte Sicherheitszeit verbleibt. So kann hier durch die Sicherheitszeit sicher gestellt werden, dass gegebenenfalls Abweichungen in der gespeicherten Berechnungszeit des Minimaltasks aufgrund bestimmter Umgebungsbedingungen nicht dazu führen, dass die Echtzeitfähigkeit des Systems beeinflusst wird.

In der Periode II ist erkennbar, dass vor dem Auslösen des Interrupts der komplexe Task mit einer höheren Berechnungszeit als der Minimaltask vollständig abgearbeitet werden konnte. Demnach wird hier durch den Taskmanager kein weiterer Task gestartet und das Ergebnis dieses komplexen Tasks als Ergebnis der Simulation verwertet.

## Patentansprüche

1. Verfahren zur Ausführung wenigstens eines Task zur Berechnung wenigstens eines zu simulierenden Signals in Echtzeit mittels eines auf einer Datenverarbeitungsanlage mit einem Echtzeitbetriebssytem in Software implementierten Taskmanagers, der periodisch jeweils nach einer vorgegebenen / vorgebbaren Periodendauer einen Task startet, welcher aus wenigstens einem vorgegebenen Eingangssignal wenigstens ein davon abhängiges Ausgangssignal berechnet, und auf der Datenverarbeitungsanlage eine Menge von wenigstens zwei verschiedenen Tasks mit unterschiedlichen Berechnungszeiten zur Berechnung desselben wenigstens einen zu simulierenden Signals ausführbar gespeichert sind und wenigstens ein Minimaltask eine Berechnungszeit kürzer als die Periodendauer aufweist, wobei der Taskmanager wenigstens einen der Tasks aus der Menge nach einer gespeicherten Strategie startet, mit welcher unter Einhaltung der Echtzeit innerhalb der gegebenen Periodendauer ein Berechnungsergebnis wenigstens eines der Tasks aus der Menge erhalten wird, **dadurch gekennzeichnet, dass** in der Datenverarbeitungsanlage eine Information über die voraussichtlich zu erwartende Berechnungszeit der einzelnen Task gespeichert ist und gemäß der gespeicherten Strategie ein Task aus der Menge mit einer Berechnungszeit größer als die des Minimaltask gestartet wird und mit dem Starten dieses Task ein Timer gestartet wird, wobei der Taskmanager in Abhängigkeit der Differenz von Periodendauer und Zeitwert des Timers den gestarteten Task abbricht und den Minimaltask startet, wobei das Abbrechen erfolgt bei einem Zeitwert des Timers, wenn die Differenz aus Periodendauer und Zeitwert um eine Sicherheitszeit größer ist als die Berechnungsdauer des Minimaltask, und wobei es sich bei dem gestarteten Task aus der Menge um einen der Tasks handelt, dessen erwartete Berechnungszeit geringer ist als die Timerzeit beim Abbruch des Task in einer vorherigen Berechnungsperiode.

2. Verfahren nach Anspruch 1, **dadurch gekennzeichnet, dass** in Abhängigkeit des Zeitwertes des Timers, insbesondere dann, wenn die Differenz aus Periodendauer und Zeitwert um eine Sicherheitszeit größer ist als die Berechnungsdauer des Minimaltask, ein Interrupt ausgelöst wird, wobei in einer durch den Interrupt gestarteten Prozedur überprüft wird, ob der Task bereits beendet ist, wobei der Task abgebrochen wird, wenn er noch nicht beendet ist.

3. Verfahren nach einem der vorherigen Ansprüche, **dadurch gekennzeichnet, dass** bei einer Beendigung des Task vor dem Interrupt der Taskmanager bis zum Ablauf der Periodendauer wartet.

4. Verfahren nach einem der vorherigen Ansprüche, **dadurch gekennzeichnet, dass** bei einer Beendigung des Task vor dem Interrupt der Taskmanager aus der Menge einen weiteren Task startet mit einer erwarteten Berechnungszeit die größer ist als die des beendeten Task.

## Claims

1. Method to perform at least one task for calculating at least one signal to be simulated in real time by means of a task manager, which is implemented in software on a data processing unit with a real time operating system, which periodically starts a task after a preset / presettable period, which from at least one preset input signal calculates at least one output signal depending on it, and a batch of at least two different tasks with different calculation times for calculating at least one signal to be simulated are stored on the data processing unit so that they may be performed and at least one minimal task has a calculation time which is shorter than the period, in which the task manager starts at least one of the tasks from the batch according to a stored strategy, with which a calculation result for at least one task from the batch is obtained within the given period whilst adhering to real time, **characterised in that** information on the calculation time of the individual task probably to be expected is stored in the data processing unit and according to the stored strategy a task from the batch with a calculation time, which is greater than that of the minimal task, is started and, when this task is started, a timer is started, in which, depending on the difference between the period and the time value of the timer, the task manager breaks off the task, which has been started, and starts the minimal task, in which it is broken off at a time value of the timer, if the difference between the period and the time value is greater than the calculation period of the minimal task by a safety time and in which the task from the batch, which has been started, is one of the tasks, the expected calculation time of which is smaller than the timer time, when the task has been broken off in a previous calculation period.

2. Method according to claim 1, **characterised in that**, depending on the value of the timer, particularly when the difference between the period and the time value is greater than the calculation period of the minimal task by a safety time, an interrupt is triggered, in which in a procedure, which has been started by the interrupt, it is verified whether the task has already ended, in which the task is broken off, if it has not yet ended.

3. Method according to one of the previous claims, **characterised in that**, when the task ends before the interrupt, the task manager waits until the expiry of the period.

4. Method according to one of the previous claims, **characterised in that**, when the task ends before the interrupt, the task manager starts a further task from the batch with an expected calculation time, which is greater than that of the task, which has ended.

## Revendications

1. Procédé pour exécuter au moins une tâche destinée à calculer au moins un signal devant être simulé en temps réel au moyen d'un gestionnaire de tâches qui est implémenté de manière logicielle dans une installation de traitement de données comportant un système d'exploitation en temps réel et qui démarre périodiquement, à chaque fois après une durée de période prédéfinie / pouvant être prédéfinie, une tâche qui calcule à partir d'au moins un signal d'entrée prédéfini au moins un signal de sortie en dépendant, et dans l'installation de traitement de données étant enregistrée de manière exécutable une quantité d'au moins deux tâches différentes ayant différents temps de calcul afin de calculer le ou les mêmes signaux devant être simulés, et au moins une tâche minimale présentant un temps de calcul plus court que la durée de période, le gestionnaire de tâches démarrant au moins une des tâches parmi la quantité selon une stratégie enregistrée avec laquelle, en respectant le temps réel à l'intérieur de la durée de période donnée, on obtient un résultat de calcul d'au moins une des tâches de la quantité,
**caractérisé en ce que**, dans l'installation de traitement de données est enregistrée une information sur le temps de calcul vraisemblable à attendre des différentes tâches et, selon la stratégie enregistrée, une tâche parmi la quantité ayant un temps de calcul plus grand que celui de la tâche minimale est démarrée et une minuterie est démarrée avec le démarrage de cette tâche, sachant que le gestionnaire de tâches interrompt la tâche démarrée en fonction de la différence entre la durée de période et la valeur temporelle de la minuterie et démarre la tâche minimale, l'interruption ayant lieu pour une valeur temporelle de la minuterie lorsque la différence entre la durée de période et la valeur temporelle est plus grande d'un temps de sécurité que la durée de calcul de la tâche minimale, et la tâche démarrée parmi la quantité étant une des tâches dont le temps de calcul attendu est inférieur au temps de la minuterie lors de l'interruption de la tâche dans une période de calcul précédente.

2. Procédé selon la revendication 1, **caractérisé en ce que**, en fonction de la valeur temporelle de la minuterie, en particulier lorsque la différence entre la durée de période et la valeur temporelle est plus grande d'un temps de sécurité que la durée de calcul de la tâche minimale, une interruption est déclenchée, une procédure démarrée par l'interruption vérifiant si la tâche est déjà terminée, la tâche étant interrompue si elle n'est pas encore terminée.

3. Procédé selon l'une quelconque des revendications précédentes, **caractérisé en ce que**, en cas de fin de la tâche avant l'interruption, le gestionnaire de tâches attend jusqu'à l'expiration de la durée de période.

4. Procédé selon l'une quelconque des revendications précédentes, **caractérisé en ce que**, en cas de fin de la tâche avant l'interruption, le gestionnaire de tâches démarre une autre tâche de la quantité ayant un temps de calcul attendu qui est plus grand que celui de la tâche terminée.
